(19)

**Europäisches Patentamt**

**European Patent Office**

**Office européen des brevets**

(11) **EP 3 770 617 B1**

(12) # EUROPÄISCHE PATENTSCHRIFT

(45) Veröffentlichungstag und Bekanntmachung des Hinweises auf die Patenterteilung:
**06.09.2023 Patentblatt 2023/36**

(21) Anmeldenummer: **19188511.0**

(22) Anmeldetag: **26.07.2019**

(51) Internationale Patentklassifikation (IPC):
***G01R 31/62*** *(2020.01)*

(52) Gemeinsame Patentklassifikation (CPC):
**G01R 31/62;** G01R 31/50

(54) **VERFAHREN UND SYSTEM ZUR ÜBERWACHUNG MINDESTENS EINES INDUKTIVEN BETRIEBSMITTELS**

METHOD AND SYSTEM FOR MONITORING AT LEAST ONE INDUCTIVE OPERATING EQUIPMENT

PROCEDE ET SYSTEME DE SURVEILLANCE D'AU MOINS UN SYSTEME INDUCTIF ÉQUIPEMENT DE FONCTIONNEMENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**27.01.2021 Patentblatt 2021/04**

(73) Patentinhaber: **Maschinenfabrik Reinhausen GmbH**
**93059 Regensburg (DE)**

(72) Erfinder:
- **VIERECK, Karsten**
  **93049 Regensburg (DE)**
- **ILGEVICIUS, Audrius**
  **93059 Regensburg (DE)**
- **HEGER, Michael**
  **94315 Straubing (DE)**
- **DREGER, Andreas**
  **61476 Kronberg im Taunus (DE)**

(56) Entgegenhaltungen:
**CN-A- 103 245 857      CN-A- 106 934 142**
**CN-A- 107 330 286      DE-A1-102017 101 413**

- **LEFENG CHENG ET AL: "Hot Spot Temperature and Grey Target Theory-Based Dynamic Modelling for Reliability Assessment of Transformer Oil-Paper Insulation Systems: A Practical Case Study", ENERGIES, Bd. 11, Nr. 1, 19. Januar 2018 (2018-01-19), Seite 249, XP055652570, DOI: 10.3390/en11010249**
- **HE JIAN ET AL: "Transformer real-time reliability model based on operating conditions", JOURNAL OF ZHEJIANG UNIVERSITY SCIENCE A, ZHEIJIANG UNIVERSITY PRESS, CN, Bd. 8, Nr. 3, 31. März 2007 (2007-03-31), Seiten 378-383, XP036040305, ISSN: 1673-565X, DOI: 10.1631/JZUS.2007.A0378 [gefunden am 2007-03-01]**

EP 3 770 617 B1

**Beschreibung**

Die Erfindung betrifft ein Verfahren zur Überwachung mindestens eines induktiven Betriebsmittels. Das Betriebsmittel kann in einem Energieversorgungsnetz eingesetzt werden.

Ferner betrifft die Erfindung ein System zur Überwachung mindestens eines induktiven Betriebsmittels in einem Energieversorgungsnetz.

Übliche Energieversorgungsnetze umfassen eine Vielzahl an Betriebsmitteln wie Leistungsschalter, Trennschalter, Erdungsschalter, Kuppelschalter, Spannungswandler, Stromwandler, Leistungstransformatoren, Oberleitungen, Erdkabel und dergleichen. Der Begriff Energieversorgungsnetz wird im Folgenden definiert als ein System zur Übertragung und/oder Verteilung von elektrischer Energie. Beispielsweise kann das System ein gesamtes Energieübertragungs- und -verteilungssystem, ein Umspannwerk, eine Vielzahl von Umspannwerken, ein Abschnitt einer Übertragungsleitung, ein Abschnitt einer Versorgungsleitung und dergleichen sein.

Um die störungsfreie Energieversorgung sicherzustellen sind Verfahren und Systeme bekannt, welche die Zuverlässigkeit eines Energieversorgungsnetzes überwachen. Eine wichtige Kenngröße stellt dabei die zustandsabhängige Ausfallrate der einzelnen Betriebsmittel dar. Der Begriff Ausfallrate wird im Folgenden definiert als die Anzahl der Ausfälle eines Betriebsmittels pro Zeiteinheit. Der Begriff Ausfall wird im Folgenden definiert wird als eine Beendigung der Fähigkeit des induktiven Betriebsmittels, eine geforderte Funktion zu erfüllen.

Aus der US 7,272,516 B2 ist ein Verfahren und System zur Analyse der Zuverlässigkeit eines Stromnetzes bekannt, welches die Ausfallrate der einzelnen Komponenten und Unterkomponenten eines Stromnetzes ermittelt und an den aktuellen Zustand anpasst.

DE 10 2017 101413 A1 beschreibt ein Verfahren zur Einsatzplanung von Betriebsmitteln eines elektrischen Systems zur Energieversorgung, wobei anhand von aktuell ermittelten Kenngrößen und statischen Parameterdaten des elektrischen Betriebsmittels ein prognostizierter Zustandsindex für einen festgelegten, zukünftigen Zeitpunkt ermittelt und anhand dessen eine Prognose für die zukünftige Verfügbarkeit des Betriebsmittels erstellt wird. Das Verfahren zielt auf eine optimierte Betriebsführung von Netzen ab.

CN 106 934 142 A beschreibt ein Verfahren zur Modellierung eines Überlast-Leistungsbewertungsmodells für einen Transformator unter Einbezug von Betriebsplanungs- und Produktionsdaten und unter Berücksichtigung von Faktoren, die das Überlastverhalten des Transformators beeinflussen, wie z. B. die Hot-Spot-Temperatur. Dabei wird mittels einem bekannten Wärmeleitungsmodell die Hot-Spot-Temperatur modelliert und eine maximale Belastungsrate des Transformators für einen stabilen Betrieb innerhalb einer begrenzten Zeit ermittelt. Das Modell wird evaluiert, indem die Hot-Spot-Temperatur mit einem Grenzwert abgeglichen wird. Liegt die Temperatur unter dem Grenzwert, so erfolgt eine Anpassung des Modells.

Weiterhin sind aus Normen und Richtlinien, beispielsweise IEEE- oder IEC-Normen, statische Überlastgrenzwerte für induktive Betriebsmittel, wie zum Beispiel Transformatoren oder Drosseln, vorgegeben. Als wichtigste Kenngröße für den Belastungsspielraum und damit auch die Lebensdauer des induktiven Betriebsmittels gilt die Heißpunkt- oder auch Hot-Spot-Temperatur. Die Heißpunkt-Temperatur ist die höchste Temperatur in einer Wicklung und ist im Inneren der Wicklung zu erwarten. Die direkte Messung der Temperatur im Inneren einer Wicklung ist zwar möglich, jedoch teuer und kompliziert. Daher hat sich die indirekte Messmethode bewährt, die auf der Messung der Öltemperatur und des Stromes basiert.

Aufgabe der vorliegenden Erfindung ist es, ein Verfahren zur Überwachung mindestens eines induktiven Betriebsmittels bereitzustellen, welches ein verbessertes Konzept für den Einsatz eines induktiven Betriebsmittels in einem Energieversorgungsnetz angibt.

Diese Aufgabe wird durch ein Verfahren zur Überwachung mindestens eines induktiven Betriebsmittels gelöst, das die Merkmale des Anspruchs 1 umfasst.

Ferner ist es Aufgabe der vorliegenden Erfindung, ein System zur Überwachung mindestens eines induktiven Betriebsmittels bereitzustellen, welches ein verbessertes Konzept für den Einsatz eines induktiven Betriebsmittels in einem Energieversorgungsnetz bereitstellt und ermöglicht.

Diese Aufgabe wird durch ein System zur Überwachung mindestens eines induktiven Betriebsmittels in einem Energieversorgungsnetz gelöst, das die Merkmale des Anspruchs 10 umfasst.

Das verbesserte Konzept beruht auf der Idee, Echtzeitdaten in Bezug auf den aktuellen Zustand des induktiven Betriebsmittels zu erfassen, basierend darauf einen Zustandsfaktor des induktiven Betriebsmittels zu ermitteln und in Abhängigkeit von dem Zustandsfaktor eine Ausfallrate für das induktive Betriebsmittel zu ermitteln. In Abhängigkeit von der Ausfallrate wird dann eine maximal erlaubte Heißpunkt-Temperatur des induktiven Betriebsmittels angegeben.

Gemäß dem verbesserten Konzept wird ein Verfahren zum Einsatz eines induktiven Betriebsmittels in einem Energieversorgungsnetz angegeben. Dabei werden Echtzeitdaten in Bezug auf den aktuellen Zustand des induktiven Betriebsmittels erfasst, basierend auf den erfassten Echtzeitdaten ein Zustandsfaktor des induktiven Betriebsmittels ermittelt und in Abhängigkeit von dem Zustandsfaktor eine Ausfallrate für das induktive Betriebsmittel zu ermittelt. In Abhängigkeit von der Ausfallrate wird dann eine maximal erlaubte Heißpunkt-Temperatur des induktiven Betriebsmittels ermittelt.

Der Vorteil des erfindungsgemäßen Verfahrens und des Systems ist, dass die für die Ermittlung der Auslastungsgrenze des induktiven Betriebsmittels ermittelte, maximal erlaubte Heißpunkt-Temperatur neben statistischen und historischen Informationen den aktuellen Zustand des induktiven Betriebsmittels berücksichtigt.

Mittels des Verfahrens wird eine maximal erlaubte Heißpunkt-Temperatur des induktiven Betriebsmittels ermittelt, die auf den aktuellen Zustand des Betriebsmittels angepasst ist. Auf diese Weise kann die Auslastungsgrenze des induktiven Betriebsmittels erhöht bzw. besser ausgenutzt werden für den Fall, dass das induktive Betriebsmittel zusätzliche Last aufnehmen kann, oder herabgesetzt werden kann, wenn das induktive Betriebsmittel in einem Zustand ist, in dem es keine zusätzliche Last aufnehmen kann, ohne dass dabei die Betriebssicherheit gefährdet wird. Zudem kann die Auslastungsgrenze aufgrund der Verwendung von aktuellen Messwerten bei der Ermittlung genauer bestimmt werden.

Echtzeitdaten in Bezug auf den aktuellen Zustand des induktiven Betriebsmittels sind Daten basierend auf den aktuellen Betriebsbedingungen des induktiven Betriebsmittels oder Komponenten davon. Insbesondere sind Echtzeitdaten Messwerte, die erfasst werden, während das induktive Betriebsmittel im Betrieb ist, wie zum Beispiel die Isoliermitteltemperatur, der Laststrom, die Betriebsspannung, die Stufenschalterstellung, die Wicklungstemperatur. Gemäß zumindest einer Ausführungsform ist das induktive Betriebsmittel als Transformator oder Drossel ausgebildet.

Gemäß zumindest einer Ausführungsform ist die Ausfallrate als normierter Wert ausgebildet.

Gemäß zumindest einer Ausführungsform ist das Verfahren anwendbar sowohl für kurzzeitige Überlasten, das heißt ein induktives Betriebsmittel übernimmt die Last eines anderen induktiven Betriebsmittels, das kurzzeitig ausfällt, beispielsweise wegen Wartungsarbeiten, als auch für langzeitige Überlasten, wie sie beispielsweise im Normalbetrieb und bei zyklischen Lastverteilungen anfallen können.

Der Begriff Überlast wird im Folgenden definiert als eine Last, die über der durch den Hersteller des induktiven Betriebsmittels definierten Nennleistung des induktiven Betriebsmittels liegt.

Gemäß zumindest einer Ausführungsform wird in Abhängigkeit von der maximal erlaubten Heißpunkt-Temperatur die Überlastfähigkeit des induktiven Betriebsmittels ermittelt.

Gemäß zumindest einer Ausführungsform wird die Überlastfähigkeit anhand eines thermischen Modells gemäß IEC- oder IEEE-Norm, insbesondere der Normen IEC 60076-7 oder IEEE C57.91 ermittelt.

Gemäß zumindest einer Ausführungsform werden die Echtzeitdaten mittels eines Sensors oder mehrerer Sensoren erfasst, beispielsweise mittels Temperatursensoren, Feuchtesensoren, DGA-Sensoren, Teilentladungssensoren, Messeinrichtungen für die Ermittlung der Durchführungskapazität oder Sensoren für die Ermittlung der Frequenz der Kühlanlagenlüfter.

Gemäß zumindest einer Ausführungsform werden die Echtzeitdaten mittels Messwandlern für Strom und/oder Spannung, Online-DGA-Analysen, oder sonstigen, am induktiven Betriebsmittel durchgeführten Tests, während dieses an das Energieversorgungsnetz angeschlossen ist, ermittelt.

Gemäß zumindest einer Ausführungsform umfasst das Ermitteln der Ausfallrate das Erfassen einer Offline-Ausfallrate basierend auf historischen Daten in Bezug auf das Betriebsmittel, das Erfassen einer Statistik-Ausfallrate basierend auf statistischen Daten in Bezug auf das induktive Betriebsmittel und/oder mehrere induktive Betriebsmittel sowie das Ermitteln einer Online-Ausfallrate basierend auf den erfassten Echtzeitdaten in Bezug auf den aktuellen Zustand des induktiven Betriebsmittels.

Gemäß zumindest einer Ausführungsform werden die Ausfallraten in Abhängigkeit von der Signifikanz und/oder Verfügbarkeit und/oder Qualität der jeweiligen Daten gewichtet, wobei die Ausfallrate FR ermittelt wird aus den gewichteten Ausfallraten.

Gemäß zumindest einer Ausführungsform umfassen historische Daten in Bezug auf das induktive Betriebsmittel Daten basierend auf in der Vergangenheit durchgeführten Wartungen und/oder Inspektionen und/oder Prüfungen an dem induktiven Betriebsmittel oder Komponenten davon, und/oder bei der Inbetriebnahme ermittelter Daten betreffend das Betriebsmittel oder Komponenten davon. Insbesondere sind historische Daten Messwerte basierend auf durchgeführten Analysen und/oder Messungen an dem induktiven Betriebsmittel oder Komponenten davon, während das induktive Betriebsmittel nicht an das Energieversorgungsnetz angeschlossen war. Insbesondere umfassen die historischen Daten Informationen, die von Offline-Zustandsbewertungssystemen ermittelt werden, wie beispielsweise technische Daten betreffend Alter, Hersteller, Modell des induktiven Betriebsmittels, Lastprofile, Ergebnisse aus Offline-DGA-Analysen oder sonstiger Ölanalysen, insbesondere Ölqualitätsparameter, Informationen basierend auf Bewertungen der Durchführungen durch Thermografie und/oder elektrische Messungen, Informationen basierend auf Bewertungen des Kessels und des Zubehörs durch visuelle Inspektionen, Informationen basierend auf dynamischen Widerstandsmessungen oder FRA (Frequency Response Analysis).

Gemäß zumindest einer Ausführungsform umfassen statistische Daten in Bezug auf das induktive Betriebsmittel Daten betreffend die Lebensdauer des Betriebsmittels oder Komponenten davon und/oder vom Alter des induktiven Betriebsmittels oder der Komponenten abhängige Daten. Insbesondere sind die statistischen Daten betreiberspezifische Daten betreffend das Betriebsmittel oder Komponenten davon, die durch den Betriebsmittelbetreiber erfasst und gespeichert werden und/oder Daten aus statistischen Umfragen, wie zum Beispiel der Umfrage "Cigre A2.37 TB642 - Transformer Reliability Survey".

Gemäß zumindest einer Ausführungsform wird die Online-Ausfallrate basierend auf den erfassten Echtzeitdaten in Bezug auf den aktuellen Zustand des induktiven Betriebsmittels während dem laufenden Betrieb des induktiven Betriebsmittels ermittelt.

Gemäß zumindest einer Ausführungsform umfasst das Ermitteln der Ausfallrate außerdem das Bestimmen relevanter Komponenten des induktiven Betriebsmittels, die maßgeblich sind für das Bestimmen der Ausfallrate, das Erfassen von Echtzeitdaten in Bezug auf den aktuellen Zustand der relevanten Komponenten des induktiven Betriebsmittels, das Ermitteln eines Zustandsfaktors für jede relevante Komponente basierend auf den erfassten Daten, das Ermitteln einer Fehlerrate für jede relevante Komponente basierend auf dem ermittelten Zustandsfaktor, wobei die Gesamt-Ausfallrate für das induktive Betriebsmittel aus den Fehlerraten der relevanten Komponenten ermittelt wird.

Relevante Komponenten können insbesondere Komponenten sein, deren Ausfall einen Ausfall des induktiven Betriebsmittels zur Folge oder Auswirkungen auf die Ausfallrate des induktiven Betriebsmittels haben kann, wie zum Beispiel ein Stufenschalter oder eine Durchführung.

Gemäß zumindest einer Ausführungsform sind relevante Komponenten des induktiven Betriebsmittels Laststufenschalter und/oder Isoliermittel und/oder feste Isolierstoffe und/oder Kühlanlagen und/oder Durchführungen und/oder Wicklungen und/oder Kerne.

Gemäß zumindest einer Ausführungsform umfasst das Verfahren außerdem das Ermitteln von Prognosedaten in Bezug auf den zukünftigen Zustand des induktiven Betriebsmittels, das Ermitteln einer prognostizierten Überlastfähigkeit basierend auf den Prognosedaten, die Bewertung der ermittelten Überlastfähigkeit anhand der Abweichung zur prognostizierten Überlastfähigkeit. Das Erfassen der Prognosedaten kann dabei insbesondere eine Übernahme von Prognosedaten aus einem übergeordneten Kommunikationssystem, wie z. B. dem Leitsystem und/oder Wetterdiensten, oder die Ermittlung von Prognosedaten basierend auf Messungen am Betriebsmittel umfassen.

Gemäß zumindest einer Ausführungsform wird die prognostizierte Überlastfähigkeit ermittelt durch Ermitteln eines prognostizierten Zustandsfaktors des induktiven Betriebsmittels basierend auf den Prognosedaten, ermitteln einer prognostizierten Ausfallrate für das induktive Betriebsmittel in Abhängigkeit von dem prognostizierten Zustandsfaktor, Bestimmen einer prognostizierten maximal erlaubten Heißpunkt-Temperatur in Abhängigkeit von der prognostizierten Ausfallrate.

Gemäß zumindest einer Ausführungsform wird die prognostizierte Überlastfähigkeit in Abhängigkeit von der prognostizierten maximal erlaubten Heißpunkt-Temperatur ermittelt. Insbesondere berücksichtigt die prognostizierte Überlastfähigkeit die Lebensdauer des Betriebsmittels und/oder dessen Komponenten und/oder ist vom Alter des induktiven Betriebsmittels oder/oder dessen Komponenten abhängig.

Gemäß zumindest einer Ausführungsform basieren die Prognosedaten auf der Einsatzplanung des induktiven Betriebsmittels im Energieversorgungsnetz, insbesondere der betreiberspezifischen Einsatzplanung, sowie insbesondere auf dem Lastprofil des induktiven Betriebsmittels und/oder den Umgebungsbedingungen, wie zum Beispiel der Umgebungstemperatur, der Windgeschwindigkeit, der Windrichtung und/oder der Sonneneinstrahlung und/oder auf Zuverlässigkeitsanalysen, die sich aus den Lastprofilen unter Berücksichtigung des sogenannten N-X-Kriteriums ergeben. Dieses Kriterium besagt, dass bei Ausfall einer Anzahl x von Betriebsmitteln des Systems der Betrieb oder die Funktionstüchtigkeit des Gesamtsystems sicher gewährleistet sein muss.

Gemäß zumindest einer Ausführungsform ist das induktive Betriebsmittel als Transformator ausgebildet.

Gemäß dem verbesserten Konzept wird außerdem ein System zum Einsatz eines induktiven Betriebsmittels in einem Energieversorgungsnetz angegeben. Das System umfasst eine Überwachungseinheit, die einen Datenspeicher aufweist, der Echtzeitdaten in Bezug auf den aktuellen Zustand des induktiven Betriebsmittels umfasst. Weiterhin weist die Überwachungseinheit eine Auswerteeinrichtung auf, die dazu eingerichtet ist, Echtzeitdaten in Bezug auf den aktuellen Zustand des induktiven Betriebsmittels von dem Datenspeicher zu erhalten, einen Zustandsfaktor des induktiven Betriebsmittels basierend auf den Echtzeitdaten zu ermitteln, eine Ausfallrate für das induktive Betriebsmittel in Abhängigkeit von dem Zustandsfaktor zu ermitteln, eine maximal erlaubte Heißpunkt-Temperatur in Abhängigkeit von der Ausfallrate zu bestimmen.

Gemäß zumindest einer Ausführungsform umfasst das Energieversorgungsnetz mehrere induktive Betriebsmittel, die jeweils ein System zum Einsatz des jeweiligen induktiven Betriebsmittels gemäß dem verbesserten Konzept umfassen. Insbesondere sind die mehreren Betriebsmittel gleich ausgestaltet und stellen zum Beispiel eine Transformatorflotte mit Transformatoren derselben Leistungsklasse dar.

Gemäß zumindest einer Ausführungsform ist die Auswerteeinrichtung außerdem dazu eingerichtet, in Abhängigkeit von der maximal erlaubten Heißpunkt-Temperatur die Überlastfähigkeit des induktiven Betriebsmittels zu ermitteln.

Gemäß zumindest einer Ausführungsform umfasst das System eine Anzeigeeinheit, die dazu eingerichtet ist, die ermittelte Überlastfähigkeit des induktiven Betriebsmittels anzugeben. Vorteilhafterweise wird die ermittelte Überlastfähigkeit als konkreter Wert angegeben.

Gemäß zumindest einer Ausführungsform umfasst das System eine Kommunikationseinheit, die dazu eingerichtet ist, die von der Überwachungseinheit ermittelte Überlastfähigkeit an die Anzeigeeinheit zu übermitteln.

Gemäß zumindest einer Ausführungsform ist die Kommunikationseinheit außerdem dazu eingerichtet, Prognosedaten an die Anzeigeeinheit und/oder an die Überwachungseinheit zu übermittelt. Vorteilhafterweise werden die Daten in Form von Leitsystemprotokollen übermittelt.

Gemäß zumindest einer Ausführungsform umfasst das System mindestens ein Zustandsbewertungssystem, das mit dem induktiven Betriebsmittel verbunden und dazu eingerichtet ist, historische Daten in Bezug auf das induktive Betriebsmittel zu erfassen, eine Offline-Ausfallrate basierend auf den historischen Daten in Bezug auf das induktive Betriebsmittel zu ermitteln, die Offline-Ausfallrate an die Überwachungseinheit zu übermitteln.

Gemäß zumindest einer Ausführungsform wird die Offline-Ausfallrate basierend auf dem Bayes'schen Gesetz ermittelt.

Gemäß zumindest einer Ausführungsform umfasst das System mindestens eine Zuverlässigkeitsdatenbank, die mit dem induktiven Betriebsmittel verbunden und dazu eingerichtet ist, statistische Daten in Bezug auf das induktive Betriebsmittel zu erfassen, eine Statistik-Ausfallrate basierend auf statistischen Daten in Bezug auf das induktive Betriebsmittel zu ermitteln, die Statistik-Ausfallrate an die Überwachungseinheit zu übermitteln.

Gemäß zumindest einer Ausführungsform ist die Überwachungseinheit des Systems außerdem dazu eingerichtet, Prognosedaten in Bezug auf den zukünftigen Zustand des induktiven Betriebsmittels zu erhalten, eine prognostizierte Überlastfähigkeit basierend auf den Prognosedaten zu ermitteln, die ermittelte Überlastfähigkeit anhand der Abweichung von der prognostizierten Überlastfähigkeit zu bewerten. Insbesondere werden die Prognosedaten in Form von Kommunikationsprotokollen, beispielsweise gemäß den Normen IEC 60570-5-104 oder IEC 61850, mittels der Kommunikationseinheit an die Auswerteeinheit übermittelt, welche eine prognostizierte Überlastfähigkeit für das induktive Betriebsmittel ermittelt.

Gemäß dem verbesserten Konzept wird außerdem ein induktives Betriebsmittel angegeben, insbesondere ein Transformator oder eine Drossel, welches ein System zum Einsatz des induktiven Betriebsmittels gemäß dem verbesserten Konzept umfasst.

Weitere Ausgestaltungsformen und Implementierungen des Systems und des induktiven Betriebsmittels und des Systems zur Energieversorgung ergeben sich unmittelbar aus den verschiedenen Ausgestaltungsformen des Verfahrens.

Im Folgenden wird die Erfindung anhand beispielhafter Ausführungsformen unter Bezug auf die Zeichnungen im Detail erklärt. Komponenten, die identisch oder funktionell identisch sind oder einen identischen Effekt haben, können mit identischen Bezugszeichen versehen sein. Identische Komponenten oder Komponenten mit identischer Funktion sind unter Umständen nur bezüglich der Figur erklärt, in der sie zuerst erscheinen. Die Erklärung wird nicht notwendigerweise in den darauffolgenden Figuren wiederholt.

Es zeigen

Figur 1 einen schematischen Aufbau eines induktiven Betriebsmittels, welches ein Transformator ist, mit einem beispielhaften System nach dem verbesserten Konzept;

Figur 2 einen beispielhaften Verfahrensablauf nach dem verbesserten Konzept;

Figur 3 eine grafische, beispielhafte Darstellung gemäß dem verbesserten Konzept;

Figur 4 einen schematischen, beispielhaften Aufbau eines Systems nach dem verbesserten Konzept;

Figur 5 einen weiteren schematischen, beispielhaften Aufbau eines Systems nach dem verbesserten Konzept.

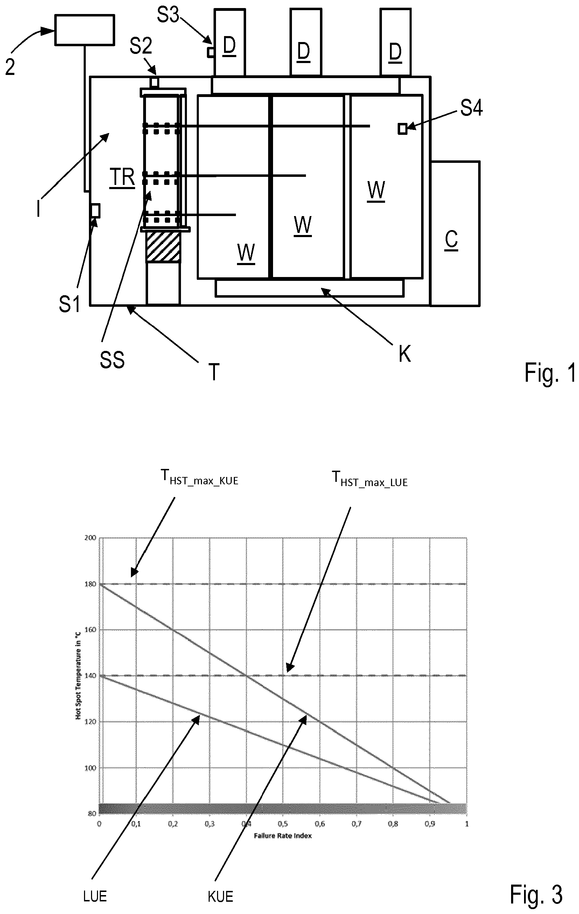

Figur 1 zeigt ein induktives Betriebsmittel TR, welches hier exemplarisch als Transformator TR, insbesondere Leistungstransformator ausgebildet ist. Obwohl sich die nachstehende Beschreibung auf einen Transformator TR oder Leistungstransformator bezieht, soll dies nicht als eine Beschränkung der Erfindung aufgefasst werden. Das induktive Betriebsmittel TR ist mit einem erfindungsgemäßen System zur Überwachung mindestens eines induktiven Betriebsmittels TR ausgestattet.

Der Transformator TR, welcher bei dieser Ausführungsform das induktive Betriebsmittel TR ist, umfasst einen Tank oder Kessel T, der beispielsweise mit einem Isoliermittel I, insbesondere einer Isolierflüssigkeit, wie z. B. Transformatoröl, gefüllt ist. Im Inneren des Tanks oder Kessels T ist der Aktivteil des Transformators TR angeordnet, insbesondere der Transformatorkern K mit den zugehörigen Transformatorwicklungen W. Der Transformator TR weist zahlreiche, weitere Komponenten, wie beispielsweise mindestens eine Durchführung D und mindestens eine Kühlung C auf. Außerdem befindet sich im Inneren des Tanks oder Kessels T zum Beispiel ein Stufenschalter SS zum Umschalten zwischen verschiedenen Wicklungsanzapfungen (nicht dargestellt) des Transformators TR. Auf die Funktionsweise des Stufenschalters, braucht hier nicht im Detail eingegangen werden, da diese eine auf dem technischen Gebiet erfahrenen Fachmann hinlänglich bekannt ist. Der Transformator TR und die Komponenten können mit mehreren Sensoren S1, S2,...,SN der unterschiedlichsten Art zur Messung von Echtzeitdaten ausgestattet sein (zum Beispiel kann ein Temperatursensor S1 zur Messung der Öltemperatur im Tank T vorgesehen sein). Die Sensoren S1, S2,..., SN sind je nach Art des Sensors S1, S2,...,SN oder der zu erfassenden Daten entweder innerhalb des Tanks T (zum Beispiel der Wicklungstemperatursensor S4 zur Messung einer Temperatur der Wicklungen W oder der Temperatursensor S1 zur Messung der Öltemperatur im Tank T) oder außerhalb des Tanks (zum Beispiel ein Betriebsspannungssensors zur Messung einer Betriebsspannung oder einer Umgebungstemperatursensor zur Messung der Umgebungstemperatur) angeordnet. Die gemessenen Echtzeitdaten werden von einer Überwachungseinheit 2 eingelesen. Diese kann kabelgebunden oder kabellos mit den Sensoren S1, S2,..., SN verbunden sein. Die Überwachungseinheit 2 kann am Transformator TR oder vom Transformator TR entfernt angeordnet sein.

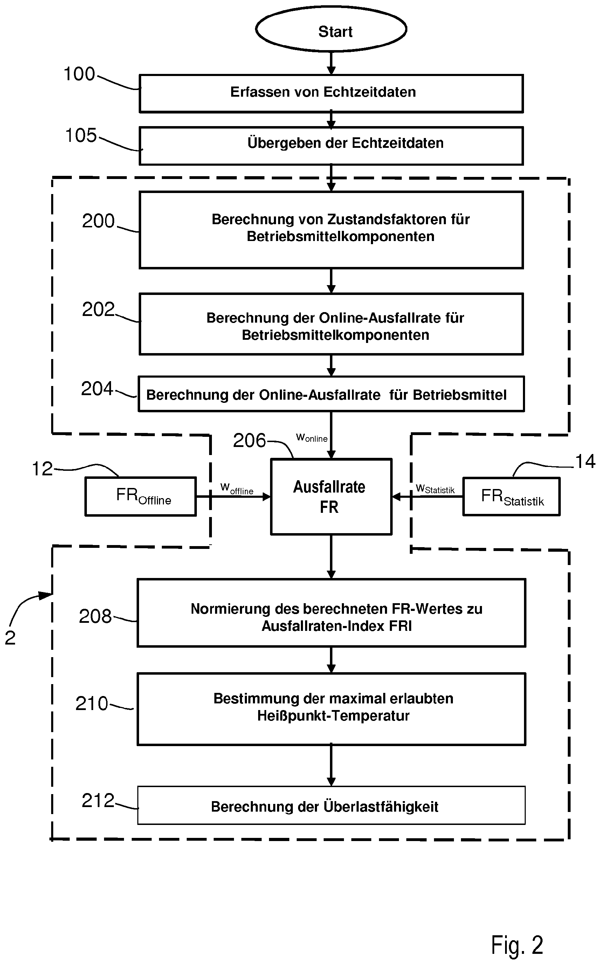

Figur 2 zeigt einen beispielhaften Verfahrensablauf des Verfahrens zur Überwachung mindestens eines induktiven Betriebsmittels TR. In einem ersten Schritt 100 erfolgt das Erfassen der Echtzeitdaten 22 durch die Sensoren S1, S2,..., SN während dem Betrieb des Transformators TR. In einem nächsten Schritt 105 erfolgt das Einlesen der Echtzeitdaten 22 in die Überwachungseinheit 2. Beispielsweise sind dies die Isoliermitteltemperatur, der Laststrom, die Betriebsspannung, die Stufenschalterstellung, die Wicklungstemperatur oder Messwerte aus einer Online-DGA-Analyse betreffend die Zusammensetzung des Isolieröls im Transformator TR oder im Stufenschalter SS, die Ölfeuchte oder die Öltemperatur.

In einem nächsten Schritt 200 wird in der Überwachungseinheit 2 der Zustandsfaktor $CF_1$, $CF_2$,..., $CF_M$ für relevante Komponenten $K_1$, $K_2$,...$K_M$ des Transformators TR durch die Funktion

$$CF_i = max(\mathrm{CP}_i)$$

ermittelt. Relevante Komponenten $K_1$, $K_2$,...$K_M$ sind beispielsweise das Isolieröl I, die Wicklungen W, die Durchführungen D, der Stufenschalter SS oder die Kühlanlage C und können durch den Transformatorbetreiber bestimmt werden. $CP_1$, $CP_2$,...,$CP_N$ sind die durch die Sensoren S1, S2,..., SN erfassten Messwerte (Echtzeitdaten 22).

In einem nächsten Schritt 202 wird in der Überwachungseinheit 2 die Online-Ausfallrate pro Komponente $K_1$, $K_2$,...$K_M$ des Transformators TR mit der Formel

$$FR_{c,i} = f(\mathrm{CF}_i)$$

berechnet. Die Funktion f(CF) kann dabei als eine beliebige Verteilfunktion definiert sein, beispielsweise als Weibull-Verteilung oder als Normalverteilung.

In einem nächsten Schritt 204 wird die Online-Ausfallrate $FR_{Online}$ für den gesamten Transformator TR, die sich aus den zuvor berechneten Online-Ausfallraten der einzelnen Komponenten $K_1$, $K_2$,...$K_M$ zusammensetzt, ermittelt:

$$FR_{Online} = \sum_{i=1}^{N} FR_{c,i}$$

In einem nächsten Schritt 206 wird die allgemeine Ausfallrate FR ermittelt:

$$FR = w1 * FR_{Online} + w2 * FR_{Offline} + w3 * FR_{Statistik}$$

Diese setzt sich aus der mit den Echtzeitdaten 22 ermittelten Online- Ausfallrate $FR_{Online}$, sowie aus der historischen Ausfallrate $FR_{Offline}$ und der statistischen Ausfallrate $FR_{Statistik}$ zusammen. $FR_{Offline}$ wird mit historischen Daten ermittelt und von einem Zustandsbewertungssystem 12 für Transformatoren TR berechnet, beispielsweise nach dem Bayes'schen Gesetz. Mit den bekannten Zustandsbewertungssystemen 12 werden aus Offline-Daten, wie beispielsweise technischen Daten, historischen Daten, Daten aus Ölprüfungen und Werksprüfungen oder sonstigen Daten, die erfasst wurden während das induktive Betriebsmittel nicht an das Energieversorgungsnetz angeschlossen war, die Wartungsdringlichkeit und/oder der Lebensdauerverbrauch eines Transformators TR und/oder einzelner Transformatorkomponenten und/oder einer Transformatorflotte angegeben. Die statistische Ausfallrate $FR_{Statistik}$ wird mit statistischen Daten von einer Zuverlässigkeitsdatenbank 14 ermittelt. Die Zuverlässigkeitsdatenbank 14 verfügt über verschiedene Statistikdaten, betreffend das Ausfallrisiko von Transformatoren TR und/oder einzelner Transformatorkomponenten und/oder einer Transformatorflotte. Beispielweise kann die Zuverlässigkeitsdatenbank 14 durch den Betriebsmittelbetreiber gepflegt werden und betreiberspezifische Daten enthalten. Die Daten können beispielsweise in Form von Überlebensfunktionen und/oder Lebensdauerverteilungsfunktionen und/oder Hazard Funktionen abgelegt werden. Beispielsweise können auch statistische Fehlerraten aus statistischen Umfragen, wie z. B. Cigre A2.37 TB642 - Transformer Reliability Survey für die Ermittlung der Ausfallrate FR verwendet werden.

Die Ausfallrate $FR_{Online}$, die historische Ausfallrate $FR_{Offline}$ und die statistische Ausfallrate $FR_{Statistik}$ werden außerdem entsprechend der Signifikanz und/oder Verfügbarkeit und/oder Qualität der jeweiligen Daten gewichtet. Beispielsweise ist die Wichtung w1 =50% für die Ausfallrate $FR_{Online}$, für die statistische Ausfallrate $FR_{Statistik}$ ist die Wichtung w2=40% und für die historische Ausfallrate $FR_{Offline}$ ist die Wichtung w3=10%.

In einem nächsten Schritt 208 wird aus der Ausfallrate (FR) ein Ausfallraten-Index FRI ermittelt:

$$FRI = 1 - \mathrm{e}^{-FR*t}$$

Dabei entspricht t der Anzahl der Betriebsjahre des Transformators TR.

Mit dem Ausfallraten-Index FRI wird somit ein normierter Wert, beispielsweise zwischen 0 und 1, für die Fehlerwahrscheinlichkeit des Transformators TR angegeben, welcher an den Zustand des Transformators TR und der Transformatorkomponenten $K_1$, $K_2$,...$K_M$ gekoppelt ist.

In einem nächsten Schritt 210 wird die maximal erlaubte Heißpunkt-Temperatur $T_{HST\_FRI}$ mit dem Ausfallraten-Index FRI an den aktuellen Zustand des Transformators TR angepasst. Dies erfolgt mit der Formel:

$$T_{HST\_FRI} = T_{HST\_max} - \left(T_{HST\_max} - T_{HST\_min}\right) * FRI$$

Der Wert für die maximale Heißpunkt-Temperatur $T_{HST\_max}$ ist entsprechend den vorgegebenen Maximalwerten für die Überlast von Transformatoren gemäß IEC- oder IEEE-Normen, insbesondere der Normen IEC 60076-7, IEEE C57.91 anzusetzen. Die Überlastfähigkeit wird im abschließenden Schritt 212 ermittelt. Beispielsweise gilt $T_{HST\_max}$= 180°C für Kurzzeitüberlast und $T_{HST\_max}$= 140°C für Langzeitüberlast. Die minimale Heißpunkt-temperatur $T_{HST\_min}$ ist hingegen betreiberspezifisch festzulegen, beispielsweise basierend auf Erfahrungswerten eines Transformator- oder Netzbetreibers. Der Wert kann abhängig von dem jeweiligen Transformator TR oder Betreiber variieren. Beispielsweise kann die minimale Heißpunkttemperatur $T_{HST\_min}$ zwischen 60 und 100°C liegen und insbesondere 98°C betragen. Figur 3 zeigt eine beispielhafte grafische Darstellung, welche die maximal erlaubte Heißpunkt-Temperatur in Abhängigkeit von dem Ausfallraten-Index FRI für Kurzzeitüberlast KUE und Langzeitüberlast LUE angibt. Für $T_{HST\_min}$ wurde beispielhaft ein Wert von 80°C festgelegt, ebenso gilt beispielhaft $T_{HST\_max\_KUE}$ = 180°C für Kurzzeitüberlast und $T_{HST\_max\_LUE}$= 140°C für Langzeitüberlast.

Beispielsweise weist ein vierzig Jahre alter Transformator erhöhte Ölfeuchte-Messwerte auf. Zusätzlich wird im Rahmen der Online-DGA-Analyse eine erhöhte Anstiegsrate der DGA-Werte angezeigt. Basierend auf diesen gemessenen Echtzeitdaten 22 wird mit dem erfindungsgemäßen Verfahren unter Einbeziehung der statistischen Ausfallrate $FR_{Statistik}$ und der historischen Ausfallrate $FR_{Offline}$ eine normierte Ausfallwahrscheinlichkeit von 0,9 ermittelt. Daraus resultiert gemäß Figur 3 eine maximal erlaubte Heißpunkt-Temperatur $T_{HST\_FR}$ von 87°C für die Langzeitzeitüberlast und eine maximal erlaubte Heißpunkt-Temperatur $T_{HST\_FR}$ von 91°C für die Kurzzeitüberlast. Ausgehend von der ermittelten, maximal erlaubten Heißpunkt-Temperatur $T_{HST\_FR}$ ist aufgrund der schlechten Ölfeuchtewerte sowie des erhöhten Gasgehalts im Transformatoröl ein Überlastbetrieb dieses Transformators nicht zulässig.

In einem weiteren Verfahrensschritt kann unter Berücksichtigung des Ausfallraten-Index FRI und der ermittelten, maximal erlaubten Heißpunkt-Temperatur $T_{HST\_FRI}$ der Überlastfaktor $K_{overload}$ gemäß dem thermischen Modell nach IEC 60076-7 oder IEEE C57.91 ermittelt werden:

$$K_{overload} = f(\mathrm{T}_{HST\_FRI}, \mathrm{T}_{Oil}, \mathrm{t}_{overload}, \mathrm{L}_{Aging})$$

Dabei entsprechen $T_{oil}$ der gemessenen und/oder berechneten Öltemperatur im Transformatortank, $t_{overload}$ dem Zeitraum bis die maximale Heißpunkt-Temperatur $T_{HST\_max}$ gemäß den IEC- oder IEEE-Normen und/oder eine gemäß den IEC- oder IEEE-Normen vorgegebene, maximale Öl Temperatur erreicht ist, und $L_{Aging}$ dem Lebensdauerverbrauch der Feststoffisolierung.

Auf diese Weise kann eine Aussage über die Überlastfähigkeit eines Transformators TR getroffen werden, die an dessen aktuellen Zustand angepasst ist, d. h. im Bedarfsfall kann die Auslastungsgrenze und insbesondere der Zeitraum, in welchem der Transformator TR eine Überlast bewältigen kann, maximal ausgereizt werden. Im Gegenzug kann beispielsweise ein Transformator TR, der in weniger gutem Zustand ist, entlastet bzw. nicht mit einer zusätzlichen Last beaufschlagt werden.

Weiterhin ist es möglich, das Verfahren dahingehend zu erweitern, dass zusätzlich Prognosedaten 24, wie Lastprofile und Wetterdaten erfasst werden, anhand derer ein prognostizierter Überlastfaktor berechnet wird, beispielsweise ebenfalls gemäß dem thermischen Modell nach IEC 60076-7 oder IEEE C57.91, und der ermittelte Überlastfaktor $K_{overload}$ anhand der Abweichung zur prognostizierten Überlastfähigkeit bewertet wird.

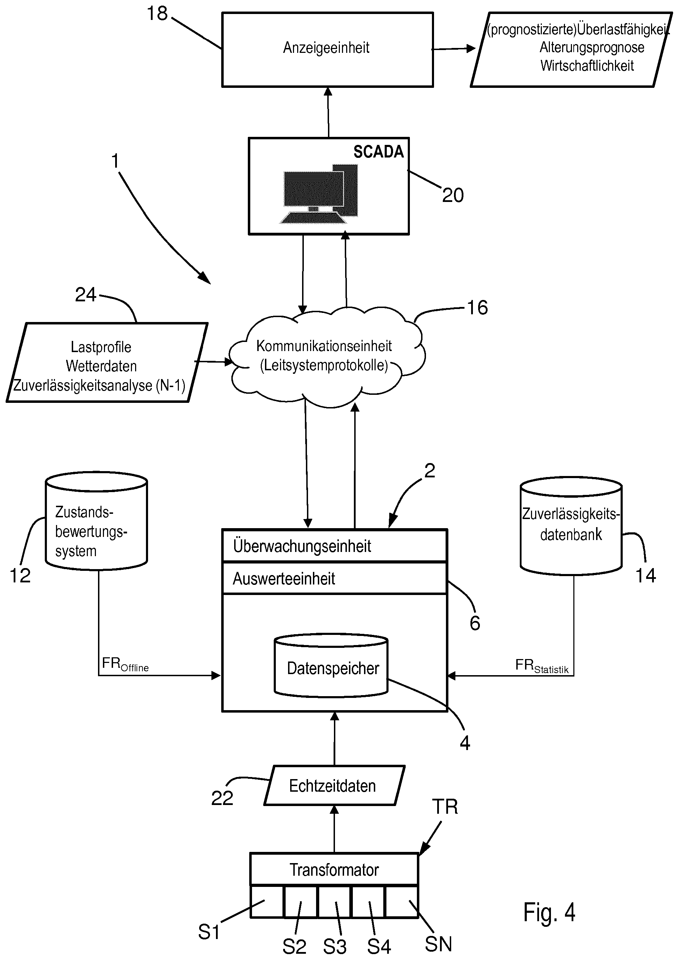

Figur 4 zeigt einen schematischen, beispielhaften Aufbau eines Systems nach dem verbesserten Konzept. Das System umfasst eine Überwachungseinheit 2 mit einem Datenspeicher 4 und einer Auswerteeinheit 6. Echtzeitdaten 22 werden über Sensoren S1, S2,..., SN, die am Betriebsmittel TR, bei diesem Ausführungsbeispiel einem Transformator TR, und an den Komponenten des Transformators TR, wie beispielsweise im Isoliermittel I (Isolieröl), am Stufenschalter SS oder an den Durchführungen D angebracht sind, erfasst und im Datenspeicher 4 gespeichert.

Die Auswerteeinheit 4 erhält die Echtzeitdaten von dem Datenspeicher 4 und führt den Algorithmus für die Berechnung der Ausfallrate FR, die darauf basierende Ermittlung der maximal erlaubten Heißpunkt-Temperatur $T_{HST\_FRI}$ sowie den Algorithmus für die Berechnung der Überlastfähigkeit $K_{overload}$ aus.

Weiterhin umfasst das System ein Zustandsbewertungssystem 12. Das Zustandsbewertungssystem 12 umfasst historische Daten, die insbesondere erfasst wurden, als der Transformator offline, das heißt nicht an das Stromnetz angeschlossen war. Diese Offline-daten sind beispielsweise technische Daten, historische Daten, Daten aus Ölprüfungen oder Werksprüfungen. Mit diesen Daten kann das Zustandsbewertungssystemen 12 beispielsweise die Wartungsdringlichkeit und/oder den Lebensdauerverbrauch eines Transformators und/oder einzelner Transformatorkomponenten und/oder einer ganzen Transformatorflotte ermitteln. Weiterhin berechnet das Zustandsbewertungssystem 12 anhand der historischen Daten eine historische Fehlerrate $FR_{Offline}$ für den jeweiligen Transformator, vorzugsweise nach dem Bayes'schen Gesetz, die an den Datenspeicher 4 übermittelt wird und in die Berechnung der gesamten Ausfallrate FR einfließt. Typische Werte für die Offline-Fehlerrate von Transformatoren ohne Auffälligkeiten sind beispielsweise 1 bis 2,5% pro Jahr. Abhängig von dem Alter und Zustand des Transformators und der Transformatorkomponenten kann die Offline-Ausfallrate von 25 bis auf 50% steigen. Anhand der ermittelten Offline-Fehlerrate für den jeweiligen Transformator können beispielsweise durch den Betreiber des Energieversorgungsnetzes Rückschlüsse auf das Ausfallrisiko der gesamten Transformatorflotte und das Energieversorgungsnetz gezogen und basierend darauf Entscheidungen hinsichtlich zu ergreifender Maßnahmen, wie beispielsweise Reparatur oder sogar Austausch von Betriebsmitteln getroffen werden.

Das System umfasst außerdem eine Zuverlässigkeitsdatenbank 14 Diese Datenbank verfügt über verschiedene Statistikdaten zum Ausfallrisiko von Transformatoren, Transformatorkomponenten und Transformatorflotten. Die Daten können beispielsweise in Form von Überlebensfunktionen, Lebensdauerverteilungsfunktionen oder Hazard-Funktionen abgelegt werden. Beispielsweise können auch statistische Fehlerraten aus statistischen Umfragen, wie z. B. der Cigre A2.37 TB642 - Transformer Reliability Survey in der Zuverlässigkeitsdatenbank gespeichert und damit eine statistische Ausfallrate $FR_{Statistik}$ ermittelt werden. Die statistische Ausfallrate $FR_{Statistik}$ wird an den Datenspeicher 4 übermittelt und fließt ebenfalls in die Berechnung der gesamten Ausfallrate FR ein.

Durch das Einfließen der statistischen und historischen Daten bzw. Ausfallraten zusätzlich zu den Echtzeitdaten 22 in die Berechnung der gesamten Ausfallrate FR können die Genauigkeit der berechneten Überlastfähigkeit $K_{overload}$ sowie deren Aussagekraft über den jeweiligen Transformator TR erhöht werden, da beispielsweise nicht alle für die Berechnung der Ausfallrate FR relevanten Daten durch die Sensoren S1, S2,....,SN erfasst werden können.

Das System umfasst außerdem eine Kommunikationseinheit 16, die dazu eingerichtet ist, die von der Überwachungseinheit 2 ermittelte Überlastfähigkeit $K_{overload}$ an eine Anzeigeeinheit 18 zu übermitteln. Die Anzeigeeinheit 18 kann beispielsweise der Bildschirm eines zentralen Server-PCs sein, der mit einer beliebigen Software für die Netzführung, beispielsweise einem Leitsystem 20 (SCADA-Leitsystem), ausgestattet ist.

Weiterhin werden über die Kommunikationseinheit 16 Prognosedaten 24, beispielsweise in Form von Lastprofilen und Wetterdaten sowie Daten aus Zuverlässigkeitsanalysen via Kommunikationsprotokollen, beispielsweise gemäß den Normen IEC 60570-5-104 oder IEC 61850, an die Anzeigeeinheit 18 und die Überwachungseinheit 2 übermittelt. Beispielsweise beinhalten die Prognosedaten 24 die zu erwartende Energieeinspeisung aus Wind- oder Photovoltaikanlagen oder Daten betreffend die Zuverlässigkeit eines Transformators TR im Fall von Überlast sowie der damit in Verbindung stehenden Ausfallkosten und Risiken.

Neben den durch die Auswerteeinheit 6 ermittelten Informationen können noch weitere Informationen, beispielsweise betreffend den Alterungsprozess im Transformator oder die Wirtschaftlichkeit des Transformators, nummerisch, tabellarisch oder graphisch über die Anzeigeeinheit 18 dargestellt werden.

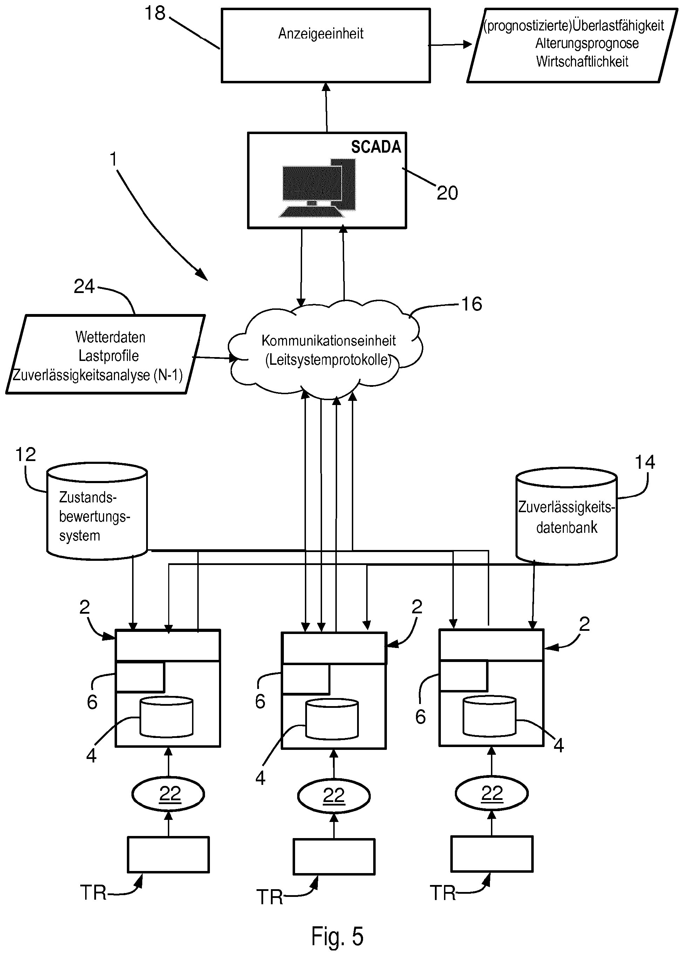

Figur 5 zeigt einen weiteren beispielhaften Aufbau eines Systems 1 nach dem verbesserten Konzept, wobei das System 1 hier eine Transformatorflotte (mehrere Betriebsmittel TR) umfasst. Jeder Transformator der Transformatorflotte umfasst eine Überwachungseinheit 2. Das Zustandsbewertungssystem 12 und die Zuverlässigkeitsdatenbank 14 übermitteln die jeweiligen Daten an die Datenspeicher 4 der jeweiligen Überwachungseinheiten 2 der Transformatoren, die Bestandteil der Flotte sind. Im Gegenzug übermitteln die Überwachungseinheiten 2 die für den jeweiligen Transformator ermittelte Überlastfähigkeit an die Kommunikationseinheit 16. In diesem Fall basiert die Online-Ausfallrate $FR_{online}$ auf Echtzeitdaten bezogen auf die ganze Transformatorflotte, das heißt, es fließen Echtzeitdaten von mehreren Transformatoren TR in die Berechnung der Fehlerrate FR ein.

**BEZUGSZEICHEN**

| | |
|---|---|
| 1 | System |
| 2 | Überwachungseinheit |
| 4 | Datenspeicher |
| 6 | Auswerteeinheit |
| 8 | Anzeigeeinheit |
| 10 | Kommunikationseinheit |
| 12 | Zustandsbewertungssystem |
| 14 | Zuverlässigkeitsdatenbank |
| 16 | Kommunikationseinheit |
| 18 | Anzeigeeinheit |
| 20 | Leitsystem |
| 22 | Echtzeitdaten |
| 24 | Prognosedaten |
| 100 | erster Schritt |
| 105 | Übergeben |
| 200 | nächster Schritt |
| 202 | nächster Schritt |
| 204 | nächster Schritt |
| 206 | nächster Schritt |
| 208 | Schritt |
| 210 | Schritt |
| 212 | abschließender Schritt |
| C | Kühlung |
| CF | Zustandsfaktor |
| CP | Echtzeitdaten |
| D | Durchführungen |
| FR | Ausfallrate |
| $FR_{online}$ | Ausfallrate aus Echtzeitdaten |
| $FR_{Offline}$ | historische Ausfallrate |
| $FR_{Statistik}$ | statistische Ausfallrate |
| I | Isoliermittel |
| K | Kern |
| $K_1, K_2, ... K_M$ | Komponente des Betriebsmittels |
| KUE | Kurzzeitüberlast |
| LUE | Langzeitüberlast |
| S1, S2,..., SN | Sensor |
| SS | Stufenschalter |
| T | Tank |
| TR | induktives Betriebsmittel; Transformator |
| W | Wicklungen |

**Patentansprüche**

1. Verfahren zur Überwachung mindestens eines induktiven Betriebsmittels (TR), das Verfahren umfasst, dass,

- ein Erfassen (100) von Echtzeitdaten (22) in Bezug auf den aktuellen Zustand des mindestens einen induktiven Betriebsmittels (TR) durchgeführt wird;
- ein Übergeben (105) der erfassten Echtzeitdaten (22) an eine Überwachungseinheit (2), die dem mindestens einen Betriebsmittel (TR) zugeordnet ist, durchgeführt wird;
- in einem nächsten Schritt (200) ein Ermitteln eines Zustandsfaktors CF des mindestens einen induktiven Betriebsmittels (TR) basierend auf den Echtzeitdaten (22) durchgeführt wird;

**dadurch gekennzeichnet, dass**

- in einem weiteren Schritt (206) ein Ermitteln einer Ausfallrate (FR) für das mindesten eine induktive Betriebsmittel (TR) in Abhängigkeit von dem Zustandsfaktor CF durchgeführt wird; und
- in einem weiteren Schritt (210) ein Bestimmen einer maximal erlaubten Heißpunkt-Temperatur in Abhängigkeit von der Ausfallrate (FR) durchgeführt wird;

wobei

- der Schritt (206) des Ermittelns der Ausfallrate (FR) ein Erfassen einer historischen Ausfallrate ($FR_{Offline}$) umfasst, die auf historischen Daten in Bezug auf das induktive Betriebsmittel (TR) basiert; ein Erfassen einer statistischen Ausfallrate ($FR_{Statistik}$) umfasst, die auf statistischen Daten in Bezug auf das induktive Betriebsmittel (TR) basiert; ein Ermitteln einer Ausfallrate ($FR_{Online}$) basierend auf den erfassten Echtzeitdaten (22) in Bezug auf den aktuellen Zustand des induktiven Betriebsmittels (TR) umfasst.

2. Verfahren nach Anspruch 1, wobei in einem abschließenden Schritt (212) in Abhängigkeit von der maximal erlaubten Heißpunkt-Temperatur die Überlastfähigkeit des mindestens einen induktiven Betriebsmittels (TR) ermittelt wird.

3. Verfahren nach Anspruch 1, wobei die Echtzeitdaten (22) des mindestens einen induktiven Betriebsmittels (TR) mittels eines oder mehrerer Sensoren (S1, S2,...,SN) erfasst werden.

4. Verfahren nach einem der vorangehenden Ansprüche, wobei der Schritt (206) des Ermittelns der Ausfallrate (FR) außerdem eine Gewichtung der historischen Ausfallrate ($FR_{Offline}$), der statistischen Ausfallrate ($FR_{Statistik}$), und der Ausfallrate ($FR_{Online}$) aus den Echtzeitdaten (22) in Abhängigkeit von der Signifikanz und/oder Verfügbarkeit und/oder Qualität der jeweiligen Daten umfasst;
wobei die Ausfallrate (FR) aus der gewichteten historischen Ausfallrate ($FR_{Offline}$), der gewichteten statistischen Ausfallrate ($FR_{Statistik}$) und der gewichteten Ausfallrate ($FR_{Online}$) aus den Echtzeitdaten (22) ermittelt wird.

5. Verfahren nach einem der vorangehenden Ansprüche, wobei das Ermitteln der Ausfallrate (FR) außerdem umfasst: ein Bestimmen relevanter Komponenten ($K_1$, $K_2$,...$K_M$) des induktiven Betriebsmittels (TR), die maßgeblich für das Bestimmen der Ausfallrate (FR) sind; ein Erfassen von Echtzeitdaten (22) in Bezug auf den aktuellen Zustand der relevanten Komponenten ($K_1$, $K_2$,...$K_M$) des induktiven Betriebsmittels (TR); ein Ermitteln eines Zustandsfaktors $CF_i$ für jede relevante Komponente ($K_1$, $K_2$,...$K_M$) basierend auf den erfassten Daten; Ermitteln einer Fehlerrate $FR_i$ für jede relevante Komponente ($K_1$, $K_2$,...$K_M$) basierend auf dem ermittelten Zustandsfaktor $CF_i$; wobei die Ausfallrate (FR) für das induktive Betriebsmittel (TR) aus den Fehlerraten $FR_i$ der relevanten Komponenten ($K_1$, $K_2$,...$K_M$) ermittelt wird.

6. Verfahren nach einem der vorangehenden Ansprüche, wobei Prognosedaten (24) in Bezug auf den zukünftigen Zustand des induktiven Betriebsmittels (TR) ermittelt werden; eine prognostizierten Überlastfähigkeit basierend auf den Prognosedaten (24) ermittelt wird, und die ermittelte Überlastfähigkeit anhand der Abweichung zur prognostizierten Überlastfähigkeit bewertet wird.

7. Verfahren nach Anspruch 6, wobei die Prognosedaten (24) auf der Einsatzplanung des mindestens einen induktiven Betriebsmittels (TR) und den Umgebungsbedingungen basieren.

8. Verfahren nach einem der vorangehenden Ansprüche, wobei ein Transformator eingesetzt wird, der das induktive Betriebsmittel (TR) ist.

9. Verfahren nach einem der vorangehenden Ansprüche, wobei mehrere induktive Betriebsmittel (TR) in einem Netzwerk miteinander verbunden sind und die induktiven Betriebsmittel (TR) überwacht werden.

10. System (1) zur Überwachung mindestens eines induktiven Betriebsmittels (TR) in einem Energieversorgungsnetz, das Systems (1) umfasst,

- eine Überwachungseinheit (2) die jedem induktiven Betriebsmittel zugeordnet ist, wobei die Überwachungseinheit (2) einen Datenspeicher (4) und eine Auswerteeinheit (6) umfasst, wobei im Datenspeicher (4) Echtzeitdaten (22) in Bezug auf den aktuellen Zustand des induktiven Betriebsmittels (TR) ablegbar sind, und die Auswerteeinheit (6) kommunikativ mit dem Datenspeicher (4) verbunden und dazu eingerichtet ist,

• Echtzeitdaten (22) in Bezug auf den aktuellen Zustand des mindestens einen induktiven Betriebsmittels (TR) vom Datenspeicher (4) zu erhalten;
• einen Zustandsfaktor CF des mindestens einen induktiven Betriebsmittels (TR) basierend auf den Echtzeitdaten (22) zu ermitteln;

**dadurch gekennzeichnet, dass**

• eine Ausfallrate (FR) für das mindestens eine induktive Betriebsmittel (TR) in Abhängigkeit von dem Zustandsfaktor (CF) ermittelt wird;
• eine maximal erlaubte Heißpunkt-Temperatur in Abhängigkeit von der Ausfallrate FR des mindestens einen Betriebsmittels (TR) bestimmt wird;

wobei
- mindestens eine Zuverlässigkeitsdatenbank (14) vorgesehen ist, die mit jeder Überwachungseinheit (2) des mindestens einen induktiven Betriebsmittels (TR) verbunden und dazu eingerichtet ist, statistische Daten in Bezug auf das mindestens eine induktive Betriebsmittel (TR) zu erfassen; eine statistische Ausfallrate ($FR_{Statistik}$) basierend auf statistischen Daten in Bezug auf das mindestens eine induktive Betriebsmittel (TR) zu ermitteln; und die statistische Ausfallrate ($FR_{Statistik}$) an die Überwachungseinheit (2) zu übermitteln.

11. System (1) nach Anspruch 10, wobei die Auswerteeinheit (6) außerdem dazu eingerichtet ist, in Abhängigkeit von der maximal erlaubten Heißpunkt-Temperatur die Überlastfähigkeit des induktiven Betriebsmittels zu ermitteln.

12. System (1) nach einem der Ansprüche 10 oder 11, wobei eine Kommunikationseinheit (16), die mit der Überwachungseinheit (2) eines jeden Betriebsmittels (TR) und einer Anzeigeeinheit (18) kommunikativ verbunden ist, wobei die Anzeigeeinheit (18) dazu eingerichtet ist, die ermittelte Überlastfähigkeit des mindestens einen induktiven Betriebsmittels (TR) anzugeben, und die Kommunikationseinheit (16) dazu eingerichtet ist, die von der Überwachungseinheit (2) ermittelte Überlastfähigkeit an die Anzeigeeinheit (18) zu übermitteln.

13. System nach einem der vorangehenden Ansprüche 10 bis 12, wobei mindestens ein Zustandsbewertungssystem (12) vorgesehen ist, das mit jeder Überwachungseinheit (2) des mindestens einen induktiven Betriebsmittels (TR) verbunden und dazu eingerichtet ist, historische Daten in Bezug auf das mindestens eine induktive Betriebsmittel (TR) zu erfassen; eine historische Ausfallrate ($FR_{Offline}$) basierend auf den historischen Daten in Bezug auf das mindesten eine induktive Betriebsmittel (TR) zu ermitteln und die historische Ausfallrate ($FR_{Offline}$) an die Überwachungseinheit zu übermitteln.

14. System (1) nach Anspruch 10, wobei die Überwachungseinheit (2) außerdem dazu eingerichtet ist, Prognosedaten (24) in Bezug auf den zukünftigen Zustand des mindestens einen induktiven Betriebsmittels (TR) zu erhalten; eine prognostizierte Überlastfähigkeit basierend auf den Prognosedaten (24) zu ermitteln; die ermittelte Überlastfähigkeit anhand von der Abweichung zur prognostizierten Überlastfähigkeit zu bewerten.

15. System (1) nach einem der vorangehenden Ansprüche 10 bis 14, wobei mehrere induktive Betriebsmittel (TR) in einem Energieversorgungsnetz verbunden sind und jedem induktiven Betriebsmittel (TR) des Energieversorgungsnetzes jeweils eine Überwachungseinheit (2) zugeordnet ist.

**Claims**

1. A method for monitoring at least one item of inductive equipment (TR), the method comprising:

- performing an operation (100) of recording real-time data (22) relating to a current condition of the at least one item of inductive equipment (TR);
- performing an operation (105) of transferring the recorded real-time data (22) to a monitoring unit (2) assigned to the at least one item of equipment (TR);
- performing an operation (200) of ascertaining a condition factor CF of the at least one item of inductive equipment (TR) based on the real-time data (22);

**characterized in that**,

- performing an operation (206) of ascertaining a failure rate (FR) for the at least one item of inductive equipment (TR) on the basis of the condition factor CF; and in a next step (210) performing an operation of determining a maximum permitted hotspot temperature on the basis of the failure rate (FR);

wherein

- the operation (206) of ascertaining the failure rate (FR) comprises recording a historical failure rate ($FR_{Offline}$), which is based on historical data relating to the item of inductive equipment (TR); recording a statistical failure rate ($FR_{Statistik}$), which is based on statistical data relating to the item of inductive equipment (TR); ascertaining an online failure rate ($FR_{Online}$) based on the recorded real-time data (22) relating to the current condition of the item of inductive equipment (TR).

2. The method as claimed in claim 1, wherein, in a final step (212), an overload capacity of the at least one item of inductive equipment (TR) is ascertained on the basis of the maximum permitted hotspot temperature.

3. The method as claimed in claim 1, wherein the realtime data (22) of the at least one item of inductive equipment (TR) are recorded using one or more sensors (S1, S2,...,SN).

4. The method as claimed in claim 1, wherein the operation (206) of ascertaining the failure rate (FR) further comprises a weighting of the historical failure rate ($FR_{Offline}$), the statistical failure rate ($FR_{Statistik}$) the online failure rate ($FR_{Online}$) from the real-time data (22) on the basis of a significance, an availability, or a quality or the respective data, and wherein the failure rate (FR) is ascertained from the weighted historical failure rate ($FR_{Offline}$), the weighted statistical failure rate ($FR_{Statistik}$), and the weighted online failure rate ($FR_{Online}$) from the real-time data (22).

5. The method according to any of the preceding claims, wherein the operation of ascertaining the failure rate (FR) further comprises: determining relevant components ($K_1, K_2,...K_M$) of the item of inductive equipment (TR), that are decisive for determining the failure rate (FR); recording real-time data (22) relating to the current condition of the relevant components ($K_1, K_2,...K_M$) of the item of inductive equipment (TR); ascertaining a condition factor $CF_i$ for each relevant component ($K_1, K_2,...K_M$) based on the recorded data; and ascertaining a fault rate $FR_i$ for each relevant component ($K_1, K_2,...K_M$) based on the ascertained condition factor $CF_i$; and wherein the failure rate (FR) for the item of inductive equipment (TR) is ascertained from the fault rates $FR_i$ of the relevant components ($K_1, K_2,...K_M$).

6. The method according to any of the preceding claims, wherein forecast data (24) relating to the future condition of the item of inductive equipment (TR) is ascertained; and a forecast overload capacity based on the forecast data (24) is ascertained, and wherein the ascertained overload capacity is assessed on the basis of the deviation from the forecast overload capacity.

7. The method as claimed in claim 6, wherein the forecast data (24) are based on the usage plan for the at least one item of inductive equipment (TR) and on the ambient conditions.

8. The method according to any of the preceding claims, wherein the item of inductive equipment (TR) comprises a transformer.

9. The method according to any of the preceding claims, wherein a plurality of items of inductive equipment (TR) are connected to one another in a grid, and the items of inductive equipment (TR) are monitored.

10. A system (1) for monitoring at least one item of inductive equipment (TR) in a power supply grid, the system (1) comprising,

- a monitoring unit (2) assigned to each of the at least one item of inductive equipment (TR), wherein the monitoring unit (2) comprises a data memory (4) and an evaluator (6), wherein the data memory (4) being configured to store real-time data (22) relating to a current condition of the item of inductive equipment (TR), and the evaluator (6) being communicatively connected to the data memory (4) and being configured to,

• obtain real-time data (22) relating to the current condition of the at least one item of inductive equipment (TR) from the data memory (4);
• ascertain a condition factor (CF) of the at least one item of inductive equipment (TR) based on the real-

12

time data (22);

**characterized in that,**

• a failure rate (FR) for the at least one item of inductive equipment (TR) is ascertained on the basis of the condition factor (CF);
• and a maximum permitted hotspot temperature is determined on the basis of the failure rate (FR) of the at least one item of equipment (TR);

wherein
- the system comprising at least one reliability database (14) connected to each monitoring unit (2) of the at least one item of inductive equipment (TR) and configured to record statistical data relating to the at least one item of inductive equipment (TR); ascertain a statistical failure rate ($FR_{Statistik}$) based on statistical data relating to the at least one item of inductive equipment (TR); and transmit the statistical failure rate ($FR_{Statistik}$) to the monitoring unit (2).

11. The system (1) as claimed in claim 10, wherein the evaluator (6) is configured to ascertain the overload capacity of the item of inductive equipment (TR) on the basis of the maximum permitted hotspot temperature.

12. The system (1) as claimed in claim 10 or claim 11, wherein a communication unit (16) is communicatively connected to the monitoring unit (2) of each of the at least one item of equipment (TR) and to a display unit (18), wherein the display unit (18) is configured to indicate the ascertained overload capacity of the at least one item or inductive equipment (TR), and the communication unit (16) is configured to transmit the overload capacity ascertained by the monitoring unit (2) to the display unit (18).

13. The system (1) according to any of the preceding claims 10 to 12, wherein the system comprising at least one condition assessment system (12) connected to each monitoring unit (2) of the at least one item of inductive equipment (TR) and is configured to record historical data relating to the at least one item or inductive equipment (TR); ascertain a historical failure rate ($FR_{Offline}$) based on the historical data relating to the at least one item or inductive equipment (TR) and transmit the historical failure rate ($FR_{Offline}$) to the monitoring unit (2).

14. The system (1) as claimed in claim 10, wherein the monitoring unit (2) is further configured to obtain forecast data (24) relating to the future condition of the at least one item of inductive equipment (TR); ascertain a forecast overload capacity based on the forecast data (24); and to assess the ascertained overload capacity on the basis or the deviation from the forecast overload capacity.

15. The system (1) according to any of the preceding claims 10 to 14, wherein a plurality of items of inductive equipment (TR) are connected in a power supply grid, and a respective monitoring unit (2) is assigned to each item of inductive equipment (TR) of the power supply grid.

**Revendications**

1. Procédé de surveillance d'au moins un équipement inductif (TR), le procédé comprenant les étapes suivantes dans lesquelles,

- une acquisition (100) de données en temps réel (22) est effectuée en relation avec l'état actuel de l'au moins un équipement inductif (TR) ;
- un transfert (105) des données en temps réel acquises (22) est effectué vers une unité de surveillance (2) qui est associée à l'au moins un équipement (TR) ;
- dans une étape suivante (200), une détermination d'un facteur d'état CF de l'au moins un équipement inductif (TR) est effectuée sur la base des données en temps réel (22) ;

**caractérisé en ce que**

- dans une étape supplémentaire (206) une détermination d'un taux de défaillance (FR) pour l'au moins un équipement inductif (TR) est effectuée en fonction du facteur d'état CF ; et
- dans une étape supplémentaire (210), une détermination d'une température de point chaud maximale admissible est effectuée en fonction du taux de défaillance (FR) ;

- l'étape (206) de détermination du taux de défaillance (FR) comprenant l'acquisition d'un taux de défaillance historique ($FR_{Offline}$) qui est basé sur des données historiques relatives à l'équipement inductif (TR) ; comprenant l'acquisition d'un taux de défaillance statistique ($FR_{Statistik}$) qui est basé sur les données statistiques relatives à l'équipement inductif (TR) ; comprenant une détermination d'un taux de défaillance ($FR_{Online}$) sur la base des données en temps réel acquises (22) en relation avec l'état actuel de l'équipement inductif (TR).

2. Procédé selon la revendication 1, dans une étape finale (212) la capacité de surcharge de l'au moins un équipement inductif (TR) étant déterminée en fonction de la température de point chaud maximale admissible.

3. Procédé selon la revendication 1, les données en temps réel (22) de l'au moins un équipement inductif (TR) étant acquises au moyen d'un ou plusieurs capteurs (S1, S2..., SN) .

4. Procédé selon l'une des revendications précédentes, l'étape (206) de détermination du taux de défaillance (FR) comprenant en outre une pondération du taux de défaillance historique ($FR_{Offline}$) , du taux de défaillance statistique ($FR_{Statistik}$) et du taux de défaillance ($FR_{Online}$) à partir des données en temps réel (22) en fonction de l'importance et/ou de la disponibilité et/ou de la qualité des données respectives ;

le taux de défaillance (FR) étant déterminé à partir du taux de défaillance historique pondéré ($FR_{Offline}$) , du taux de défaillance statistique pondéré ($FR_{Statistik}$) et du taux de défaillance pondéré ($FR_{Online}$) à partir des données en temps réel (22).

5. Procédé selon l'une des revendications précédentes, la détermination du taux de défaillance (FR) comprenant en outre : une détermination de composants pertinents ($K_1$, $K_2$,...$K_M$) de l'équipement inductif (TR) qui sont décisifs pour la détermination du taux de défaillance (FR) ; une acquisition de données en temps réel (22) relatives à l'état actuel des composants pertinents ($K_1$, $K_2$,...$K_M$) de l'équipement inductif (TR) ; une détermination d'un facteur d'état $CF_i$ pour chaque composant pertinent ($K_1$, $K_2$,...$K_M$) sur la base des données collectées ; une détermination d'un taux d'erreur $FR_i$ pour chaque composant pertinent ($K_1$, $K_2$,...$K_M$) sur la base du facteur d'état déterminé $CF_i$ ; le taux de défaillance (FR) pour l'équipement inductif (TR) étant déterminé à partir des taux d'erreur $FR_i$ des composants pertinents ($K_1$, $K_2$,...$K_M$).

6. Procédé selon l'une des revendications précédentes, des données de pronostic (24) étant déterminées en relation avec l'état futur de l'équipement inductif (TR) ; une capacité de surcharge pronostiquée étant déterminée sur la base des données de pronostic (24), et la capacité de surcharge déterminée étant évaluée sur la base de l'écart par rapport à la capacité de surcharge pronostiquée.

7. Procédé selon la revendication 6, les données de pronostic (24) étant basées sur la planification opérationnelle de l'au moins un équipement inductif (TR) et les conditions environnementales.

8. Procédé selon l'une des revendications précédentes, un transformateur étant utilisé qui est l'équipement inductif (TR).

9. Procédé selon l'une des revendications précédentes, une pluralité d'équipements inductifs (TR) étant reliés les uns aux autres dans un réseau et les équipements inductifs (TR) étant surveillés.

10. Système (1) de surveillance d'au moins un équipement inductif (TR) dans un réseau d'alimentation en énergie, le système (1) comprenant

- une unité de surveillance (2) qui est associée à chaque équipement inductif, l'unité de surveillance (2) comprenant une mémoire de données (4) et une unité d'évaluation (6), des données en temps réel (22) relatives à l'état actuel de l'équipement inductif (TR) pouvant être stockées dans la mémoire de données (4), et l'unité d'évaluation (6) étant reliée de manière communicative à la mémoire de données (4) et étant conçue,

• pour obtenir des données en temps réel (22) relatives à l'état actuel de l'au moins un équipement inductif (TR) à partir de la mémoire de données (4) ;
• pour déterminer un facteur d'état CF de l'au moins un équipement inductif (TR) sur la base des données en temps réel (22) ;

**caractérisé en ce que**

• un taux de défaillance (FR) pour l'au moins un équipement inductif (TR) est déterminé en fonction du facteur d'état (CF) ;
• une température de point chaud maximale admissible est déterminée en fonction du taux de défaillance FR de l'au moins un équipement (TR) ;

- au moins une base de données de fiabilité (14) étant prévue qui est reliée à chaque unité de surveillance (2) de l'au moins un équipement inductif (TR) et qui est conçue pour acquérir des données statistiques relatives à l'au moins un équipement inductif (TR) ; déterminer un taux de défaillance statistique ($FR_{Statistik}$) sur la base de données statistiques relatives à l'au moins un équipement inductif (TR) ; et transmettre le taux de défaillance statistique ($FR_{Statistik}$) à l'unité de surveillance (2) .

11. Système (1) selon la revendication 10, l'unité d'évaluation (6) étant en outre conçue pour déterminer la capacité de surcharge de l'équipement inductif en fonction de la température de point chaud maximale admissible.

12. Système (1) selon l'une des revendications 10 ou 11, une unité de communication (16) qui est reliée de manière communicative à l'unité de surveillance (2) de chaque équipement (TR) et à une unité d'affichage (18), l'unité d'affichage (18) étant conçue pour indiquer la capacité de surcharge déterminée de l'au moins un équipement inductif (TR), et l'unité de communication (16) étant conçue pour transmettre la capacité de surcharge déterminée par l'unité de surveillance (2) à l'unité d'affichage (18).

13. Système selon l'une des revendications précédentes 10 à 12, au moins un système d'évaluation d'état (12) étant prévu qui est relié à chaque unité de surveillance (2) de l'au moins un équipement inductif (TR) et qui est conçu pour acquérir des données historiques relatives à l'au moins un équipement inductif (TR) ; déterminer un taux de défaillance historique ($FR_{Offline}$) sur la base des données historiques relatives à l'au moins un équipement inductif (TR) et transmettre le taux de défaillance historique ($FR_{Offline}$) à l'unité de surveillance.

14. Système (1) selon la revendication 10, l'unité de surveillance (2) étant en outre conçue pour obtenir des données de pronostic (24) relatives à l'état futur de l'au moins un équipement inductif (TR) ; déterminer une capacité de surcharge pronostiquée sur la base des données de pronostic (24); évaluer la capacité de surcharge déterminée sur la base de l'écart par rapport à la capacité de surcharge pronostiquée.

15. Système (1) selon l'une des revendications précédentes 10 à 14, une pluralité d'équipements inductifs (TR) étant reliés dans un réseau d'alimentation en énergie et chaque équipement inductif (TR) du réseau d'alimentation en énergie étant associé à une unité de surveillance (2).

Fig. 1

Fig. 3

**Start**

100 — Erfassen von Echtzeitdaten

105 — Übergeben der Echtzeitdaten

200 — Berechnung von Zustandsfaktoren für Betriebsmittelkomponenten

202 — Berechnung der Online-Ausfallrate für Betriebsmittelkomponenten

204 — Berechnung der Online-Ausfallrate für Betriebsmittel

$w_{online}$

206 — Ausfallrate FR

12 — $FR_{Offline}$ — $w_{offline}$

14 — $FR_{Statistik}$ — $w_{Statistik}$

2

208 — Normierung des berechneten FR-Wertes zu Ausfallraten-Index FRI

210 — Bestimmung der maximal erlaubten Heißpunkt-Temperatur

212 — Berechnung der Überlastfähigkeit

Fig. 2

18

Anzeigeeinheit

(prognostizierte)Überlastfähigkeit
Alterungsprognose
Wirtschaftlichkeit

1

SCADA

20

24

Lastprofile
Wetterdaten
Zuverlässigkeitsanalyse (N-1)

Kommunikationseinheit
(Leitsystemprotokolle)

16

2

Zustandsbewertungssystem

12

Überwachungseinheit

Auswerteeinheit

6

Zuverlässigkeitsdatenbank

14

$FR_{Offline}$

Datenspeicher

$FR_{Statistik}$

4

22  Echtzeitdaten

TR

Transformator

S1   S2   S3   S4   SN

Fig. 4

18

Anzeigeeinheit

(prognostizierte)Überlastfähigkeit
Alterungsprognose
Wirtschaftlichkeit

1

SCADA

20

24

Wetterdaten
Lastprofile
Zuverlässigkeitsanalyse (N-1)

16

Kommunikationseinheit
(Leitsystemprotokolle)

12

Zustandsbewertungssystem

14

Zuverlässigkeitsdatenbank

2

6

4

2

6

4

2

6

4

22

22

22

TR

TR

TR

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7272516 B2
- DE 102017101413 A1
- CN 106934142 A